# EUROPEAN PATENT SPECIFICATION

(11) **EP 0 581 216 B1**
(45) Date of publication and mention of the grant of the patent: **08.01.1997**
(21) Application number: 93111854.1
(22) Date of filing: 23.07.1993
(51) Int. Cl.: C03C 17/25, C01G 23/053

(54) **Process for producing coating films of titanium oxide**
Verfahren zur Herstellung von Überzugfilmen aus Titanoxyd
Procédé de préparation de films de revêtement d'oxyde de titane

(30) Priority: 28.07.1992 JP 220677/92; 18.12.1992 JP 355716/92; 21.12.1992 JP 356212/92; 10.02.1993 JP 45872/93
(43) Date of publication of application: 02.02.1994
(60) Divisional application: 95111338.0
(73) Proprietor: ISHIHARA SANGYO KAISHA, LTD., Nishi-ku, Osaka (JP)
(72) Inventor: Okada, Mizuho, c/o Chuo Kenkyusho, Kusatsu-shi (JP); Tomonari, Masanori, c/o Chuo Kenkyusho, Kusatsu-shi (JP); Hirota, Tomoyuki, c/o Chuo Kenkyusho, Kusatsu-shi (JP)
(74) Representative: Henkel, Feiler, Hänzel & Partner

(56) References cited:
- GB-A- 2 018 234
- CERAMICS INTERNATIONAL vol. 15, no. 5, 1989, pages 255 - 270 POUSKOULELI
- DATABASE WPI Week 8637, Derwent Publications Ltd., London, GB; AN 86-240930 & JP-A-61 168 528
- APPLIED OPTICS vol. 26, no. 21, November 1987, pages 4688 - 4691 THOMAS

## Description

### BACKGROUND OF THE INVENTION

### Field of the Invention

The present invention relates to a process for producing particles and coating films of titanium oxide and more particularly to a process for producing particles and coating films of titanium oxide which are used for pigments, ultraviolet absorbers, fillers, optical materials, electronic materials, optoelectric transducers, decorative materials, catalysts, photocatalysts, catalyst carriers, adsorbents, bioreactors and the like.

### Description of Related Art

Titanium oxide particles are useful as pigments, ultraviolet absorbers, fillers and the like. Furthermore, titanium oxide coating films comprising titanium oxide particles allowed to firmly adhere to a support are useful as photocatalysts, sensors and materials for semiconductor electrodes such as solar batteries utilizing the photosemiconductor characteristics of titanium oxide and as sealing materials utilizing its dielectric characteristics. Moreover, titanium oxide coating films are used as heat ray reflecting glasses and decorative materials because of high light reflectance and beautiful silvery reflective color tone and furthermore as catalysts, photocatalysts, catalyst carriers, adsorbents and bioreactors utilizing the porosity of the titanium oxide coating films. The titanium oxide coating films can be produced, for example, by a process which comprises immersing a support in a solution containing titanium isopropoxide or the like, taking it out and then heating the support at a high temperature to form a film, a process which comprises blowing titanium tetrachloride vapor against the surface of a support at a high temperature to form a film, a process which comprises spraying a solution containing an organotitanium compound such as titanium acetylacetonato, titanium alkoxide or the like to the surface of a support at a high temperature to form a film.

According to the above-mentioned conventional processes, a titanium compound is reacted on a support to form a titanium oxide film. Therefore, the size of titanium oxide primary particles which constitute the resulting titanium oxide film is several nm and such titanium oxide particles show volume shrinkage at the time of sintering to cause occurrence of cracks in the resulting film. The film having cracks is apt to peel off from the support and is low in endurance and wear resistance and furthermore, inferior in optical characteristics. In addition, according to the conventional processes, it is difficult to make porous titanium oxide coating films having a large thickness and a large specific surface area which are suitable for optoelectric transducing materials, catalysts, photocatalysts and adsorbents. The conventional processes have further problems that the working atmosphere becomes worse due to the vapors of organic solvents and titanium compounds and there are dangers in working such as firing.

### SUMMARY OF THE INVENTION

An object of the present invention is to provide titanium oxide coating films less in cracks and high in adhesion to a support.

The present invention is a process for producing a titanium oxide coating film which comprises heat treating titanium oxide fine particles to carry out crystal growth of the fine particles, thus obtaining titanium oxide particles, then coating the resulting titanium oxide particles on a support and firing the coated support to allow the particles to firmly adhere to the support.

### BRIEF DESCRIPTION OF THE DRAWINGS

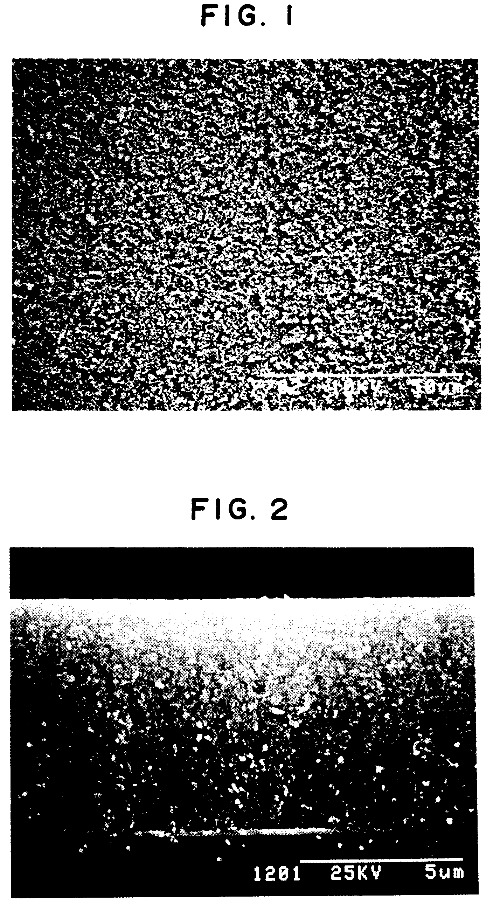

Fig. 1 is a optical photomicrograph (x 1000) which shows the surface morphologic structure of the titanium oxide coating film obtained in Example 1.

Fig. 2 is an electron photomicrograph (x 8000) which shows the layer structure of a section of the titanium oxide coating film obtained in Example 5.

### DETAILED DESCRIPTION OF PREFERRED EMBODIMENTS

The inventors have conducted intensive research in an attempt to obtain a titanium oxide coating film strong in adhesion to a support and excellent in optical properties and as a result, have found that (1) by using titanium oxide particles obtained by carrying out crystal growth of titanium oxide fine particles, volume shrinkage at the time of formation of the film can be reduced, occurrence of cracks can be reduced and adhesion to the support can be improved, (2) the titanium oxide particles which are allowed to firmly adhere are desirably those which have an average particle size of 10 to 100 nm, preferably 10 to 30 nm, especially preferably 15 to 25 nm because these are excellent in adhesion to the support, (3) for carrying out the crystal growth of titanium oxide fine particles, there are the following methods of (a) heating titanium oxide fine particles at a temperature of 200 to 600°C, (b) subjecting the titanium oxide fine particles to a hydrothermal treatment at a temperature of 100°C or higher, and (c) subjecting a suspension in which the titanium oxide fine particles are highly dispersed to a hydrothermal treatment at a temperature of 100°C or higher, and these methods are preferred because the crystals of the titanium oxide fine particles can be uniformly grown, and especially preferred is the method (b) in which titanium oxide fine particles containing rutile-type titanium oxide or titanium oxide fine particles obtained by hydrolyzing titanyl sulfate are subjected to a hydrothermal treatment, and (4) in the case of forming a titanium oxide coating film by allowing titanium oxide particles obtained by crystal growth of titanium oxide fine particles to firmly adhere to a support, the packing density of the titanium oxide coating film can be enhanced and adhesion to the support can be further improved by using a suspension in which said titanium oxide particles are highly dispersed. Thus, the present invention has been accomplished.

In the present invention, the "titanium oxide" means various titanium oxides such as anatase-type titanium oxide, rutile-type titanium oxide, amorphous titanium oxide, metatitanic acid, orthotitanic acid and the like and hydrous titanium oxide. Moreover, the "titanium oxide fine particles" means those which have a fine average particle size of 3 to 20 nm, preferably 5 to 15 nm and the "titanium oxide particles" means those having an average particle size of 10 to 100 nm, preferably 10 to 30 nm, especially preferably 15 to 25 nm obtained by crystal growth of said titanium oxide fine particles. The said titanium oxide fine particles are obtained by known processes, for example, by hydrolyzing or neutralizing titanium compounds such as titanyl sulfate, titanium chloride, titanium acetate, titanium alkoxide and the like, if necessary, in the presence of a seed. Then, the thus obtained titanium oxide fine particles are preferably filtrated and washed for removing impurities such as sulfates, chlorine and alkalis.

The "titanium oxide fine particles containing rutile-type titanium oxide" used herein means titanium oxide comprising 0.5 to 50% by weight, preferably 1 to 30% by weight of fine particles of titanium oxide which can be identified to be rutile-type crystal in the X-ray diffraction pattern and the balance being mostly amorphous. One example corresponding thereto is the rutile transition accelerating seed used in preparation of titanium dioxide pigments. The said titanium oxide fine particles containing rutile-type titanium oxide can be prepared, for example, by the following processes: ① A titanium compound such as titanyl sulfate, titanium acetate or titanium tetrachloride is neutralized with an alkali or hydrolyzed, if necessary, in the presence of nucleus crystals to obtain a precipitate and the resulting precipitate is heated, if necessary, with addition of an alkali and then is aged at a temperature of from 50°C to the boiling point with addition of an inorganic acid such as hydrochloric acid or nitric acid or an organic acid such as citric acid. ② A Titanium chloride is neutralized with an alkali at a pH of 4 to 7. ③ Titanium chloride is hydrolyzed by heating under the condition of 11% or higher in hydrochloric acid concentration. ④ Titanium chloride is subjected to an oxidative thermal decomposition in vapor phase.

The "titanium oxide fine particles obtained by hydrolysis of titanyl sulfate" used herein means titanium oxide fine particles containing anatase-type titanium oxide obtained by hydrolyzing titanyl sulfate with heating at 60 to 110°C, especially 80 to 110°C. This contains a slight amount of amorphous titanium oxide, but contains mostly titanium oxide which can be identified to be anatase-type crystal in the X-ray diffraction pattern.

When the heating temperature at the time of hydrolysis is lower than 60°C, hydrolysis of titanyl sulfate is not sufficiently performed or a long time is required for hydrolysis. The concentration of titanyl sulfate in the solution and the heating time can be optionally set, but a titanyl sulfate concentration of 50 to 250 g/l in terms of TiO₂ is suitable and a heating time of about 1 to 10 hours is suitable. The pressure at the time of heating is preferably atmospheric pressure, but the heating may be conducted under application of pressure. Furthermore, if necessary, a seed may be present in the solution of titanyl sulfate. Preferably, the thus obtained titanium oxide fine particles are filtrated and washed to remove impurities such as sulfate radicals.

The "suspension in which titanium oxide fine particles are highly dispersed" used herein is obtained by allowing an acid to be present in a suspension of titanium oxide fine particles to adjust the pH to 4 or lower, preferably 2 or lower or allowing an alkali to be present in a suspension of titanium oxide fine particles to adjust the pH to 9 or higher, preferably 10 or higher and dispersing titanium oxide fine particles or by grinding the powders of titanium oxide fine particles and then preparing a suspension thereof, or by suspending titanium oxide fine particles in a suspension with grinding the fine particles by a grinder or a classifier, or by allowing a dispersant to be present in the suspension.

When acid or alkali is allowed to be present, if pH of the suspension is higher than 4 and lower than 9, titanium oxide fine particles are dispersed with difficulty and cannot be made to a colloid solution. For adjusting the pH to 4 or lower, at least one acid optionally selected from inorganic acids such as hydrochloric acid, nitric acid, sulfuric acid, phosphoric acid and carbonic acid and organic acids such as citric acid, malic acid, acetic acid and lactic acid is added to the suspension. Hydrochloric acid or nitric acid is preferred. For adjusting the pH to 9 or higher, at least one alkali optionally selected from sodium hydroxide, potassium hydroxide, sodium carbonate, ammonium carbonate, ammonia and amines is allowed to be present. The grinders used are preferably wet grinders such as sand mill, ball mill, Henschel mixer and paint shaker. As the dispersant when this is used, mention may be made of, for example, inorganic dispersants such as sodium hexametaphosphate and sodium silicate and organic dispersants such as sodium polycarboxylates, polyethylene glycol and acetylacetone. These dispersants may be used each alone or in combination of two or more. In the present invention, organic dispersants are especially preferred and sodium polycarboxylates such as OROTAN 850 (manufactured by Rohm & Haas Co.) and polyethylene glycol are especially preferred among the organic dispersants. These dispersants can be added optionally to the suspension of titanium oxide fine particles before coating of the suspension on a support, thereby to allow them to be present in the suspension. The amount of the dispersant to be added is preferably about 0.1 to 40% by weight in terms of the effective ingredient based on the weight of the titanium oxide fine particles. In the present invention, preferred are the process of allowing an acid to be present in the suspension of titanium oxide fine particles to adjust the pH to 4 or lower, preferably 2 or lower or allowing an alkali to be present in the suspension of titanium oxide fine particles to adjust the pH to 9 or higher, preferably 10 or higher and dispersing the titanium oxide fine particles.

The hydrothermal treatment is carried out by heating the suspension or highly dispersed suspension of titanium oxide fine particles to a temperature of 100°C or higher, preferably 100 to 250°C. By this hydrothermal treatment, crystals of the titanium oxide fine particles are grown to an average particle size of 10 to 100 nm, preferably 10 to 30 nm, especially preferably 15 to 25 nm. Furthermore, by this hydrothermal treatment, the titanium oxide fine particles containing rutile-type titanium oxide become rutile-type titanium oxide particles and X-ray diffraction of this rutile-type titanium oxide particles reveals no anatase-type crystal and this rutile-type titanium oxide particles have substantially rutile-type crystal structure. The titanium oxide fine particles containing anatase-type titanium oxide become anatase-type titanium oxide particles by the hydrothermal treatment. X-ray diffraction of this anatase-type titanium oxide particles reveals that the particles show substantially anatase-type crystal structure. The thus obtained rutile-type titanium oxide particles or anatase-type titanium oxide particles can have the desired particle size by suitably setting the temperature and time of the hydrothermal treatment. By subjecting the suspension in which titanium oxide fine particles are highly dispersed to the hydrothermal treatment, the effect of the hydrothermal treatment can be further enhanced.

The hydrothermal treatment is preferably carried out under about saturated vapor pressure, but can also be carried out under higher than the saturated vapor pressure or under about atmospheric pressure and can normally be carried out by industrially employed heat-resisting and pressure-resisting apparatuses. The time for the hydrothermal treatment can be optionally set, but is suitably about 1 to 48 hours.

If necessary, the titanium oxide particles obtained by the hydrothermal treatment are filtrated and washed to remove impurities such as sulfate radicals, chlorine and alkalis, and dried to make dry powders. The drying can be carried out at optional temperatures, but suitable is 100 to 500°C. Furthermore, it is also possible depending on the using sites to use the titanium oxide particles by supporting or coating them on a support or by grinding or molding the above dry powders. It is also possible depending on the catalytic reactions used to support transition metals such as gold, platinum, rhodium and palladium on the surface of the titanium oxide particles.

After the titanium oxide particles obtained by carrying out the crystal growth of the titanium fine particles have been coated onto a support they are fired to obtain the desired titanium oxide coating film.

The "titanium oxide coating film" obtainable by the present invention means a coating film containing substantially no resin, being different from the general coating films comprising a titanium oxide pigment and a resin medium. Furthermore, it has a large specific surface area of about 10 to 200 cm² per 1 cm² of the support and 1 µm of a film thickness. The titanium oxide coating film obtained by the present invention can be optionally changed in its thickness, transparency and porosity expressed by specific surface area by suitably setting the conditions such as concentration of titanium oxide suspension and particle size of the titanium oxide particles explained hereinafter. Moreover, the titanium oxide coating film of either anatase-type or rutile-type can be formed by suitably selecting the crystal system of the titanium oxide particles used or by suitably setting the firing conditions. Furthermore, it is also possible to form a coating film comprising a mixture of anatase-type titanium oxide particles and rutile-type titanium oxide particles at an optional proportion. The thickness of the film can be, for example, about 0.5 to 20 µm. The titanium oxide particles having an average particle size of 10 to 100 nm, preferably 10 to 30 nm, especially preferably 15 to 25 nm are superior in adhesion to the support.

The method for growing the crystals of the titanium oxide fine particles includes, for example, (a) a method of heating them at a temperature of 200 to 600°C, preferably 300 to 500°C, especially preferably 300 to 450°C and (b) the above-mentioned method of subjecting them to hydrothermal treatment at a temperature of 100°C or higher, preferably 100 to 250°C.

When the heating temperature is lower than 200°C, crystal growth of the titanium oxide fine particles is not sufficient and volume shrinkage of titanium oxide particles when allowed to firmly adhere to a support is great and cracks are apt to occur and adhesion to the support becomes inferior. When the heating temperature is higher than 600°C, the crystals of the titanium oxide fine particles grow too much and adhesion to the support is deteriorated or the specific surface area of the titanium oxide coating film decreases. The heating time is suitably 0.5 to 2 hours.

By carrying out the above heating treatment or hydrothermal treatment, crystals of the titanium oxide fine particles grow and crystallinity is improved and uniform titanium oxide particles of suitable size can be obtained. Thus, the desired titanium oxide coating film can be obtained.

In the present invention, the titanium oxide particles obtained by carrying out the crystal growth of the titanium oxide particles are first suspended in a solvent such as water, alcohol, toluene or the like. As the solvent, water is especially preferred from the point of working atmosphere. The concentration of the titanium oxide particles in the suspension can be optionally set, but a concentration of 10 to 1200 g/l in terms of TiO₂ is preferred. When the concentration is lower than 10 g/l, it becomes difficult to increase the thickness of the titanium oxide coating film. When it is higher than 1200 g/l, viscosity of the suspension increases and the suspension can be coated on a support with difficulty. In the present invention, it is preferred to increase the concentration by subjecting the titanium oxide particles in the suspension to the aforementioned dispersion treatment. Furthermore, the suspension of the titanium oxide particles obtained by the hydrothermal treatment can be coated as it is or after adjusting the concentration of the titanium oxide particles without carrying out the filtration of the titanium oxide particles on a support by various coating methods mentioned hereafter and thus, a titanium oxide coating film can be obtained.

The resulting suspension of titanium oxide particles is coated on a support by usual methods such as dip coating, spray coating, spinner coating, blade coating, roller coating, wire bar coating and reverse roll coating and, if necessary, dried and fired to remove the solvent, and the titanium oxide particles are allowed to firmly adhere to the support. Material, shape and size of the support on which the titanium oxide film is formed can be optionally selected depending on the object and its use. As the material there may be used glass, metals, ceramics and others, and as the shape and size mention may be made of a card board, a small fragment, spheres such as beads. The firing is carried out at 100°C or higher, preferably 200 to 800°C, especially preferably 300 to 800°C. When the firing temperature is lower than 100°C, adhesion to the support deteriorates. The upper limit of the firing temperature depends on the use and cannot be generically specified, but the firing temperature higher than 800°C is not preferred in so me case because crystal growth of the titanium oxide particles is too much or the specific surface area of the titanium oxide coating film is small. In the case of carrying out the heating for crystal growth, the firing is carried out at a temperature higher than the heating temperature. When the firing temperature for adhesion of the particles is lower than the heating temperature for the crystal growth, adhesion to the support is inferior.

In the present invention, it is preferred to use titanium oxide particles obtained by subjecting the suspension in which the titanium oxide fine particles are highly dispersed to the hydrothermal treatment. Furthermore, for producing a titanium oxide coating film comprising rutile-type titanium oxide particles, it is preferred to use the titanium oxide particles comprising substantially rutile-type titanium oxide obtained by subjecting the titanium oxide fine particles containing rutile-type titanium oxide to a hydrothermal treatment at a temperature of 100°C or higher. For producing a titanium oxide coating film of anatase-type titanium oxide, it is preferred to use the substantially anatase-type titanium oxide particles obtained by hydrolyzing titanyl sulfate and then subjecting the resulting titanium oxide fine particles to a hydrothermal treatment at a temperature of 100°C or higher.

In this way, the titanium oxide film of the present invention is obtained.

The present invention is illustrated by the following examples.

### Example 1

One liter of a solution containing 80 g/l of titanyl sulfate was heated to 85°C to carry out hydrolysis. Then, the product was filtrated and washed to obtain a wet cake. Successively, water in this wet cake was replaced with acetone and then, the cake was subjected to vacuum drying at 60°C to obtain titanium oxide fine particle powders. (X-ray diffraction of the resulting titanium oxide fine particles showed that the product had anatase-type crystal structure and had a particle size of 5 nm.)

Then, the titanium oxide fine particle powders were heated at 300°C for 1 hour to obtain titanium oxide particles having anatase-type crystal structure of 11 nm in particle size. Then, the resulting titanium oxide particles were ground by an attritor and introduced into water. Thereafter, to this water was added polyethylene glycol (average molecular weight: 15000-25000) in an amount of 20% by weight of TiO₂, followed by sufficient shaking by a paint conditioner (manufactured by Red Davil Co.) to obtain a suspension containing 500 g/l of titanium oxide particles. Then, this suspension was coated on a glass plate by a doctor blade (slit: 60 µm) and air-dried and then, fired at 450°C for 2 hours to obtain a titanium oxide coating film (anatase-type crystal, hazed) of the present invention.

This titanium oxide coating film firmly adhered to the glass plate (support) and the film was observed under a light microscope to find substantially no cracks on the surface. This titanium oxide coating film had a thickness of 10 µm measured by a feeler type film thickness gauge and had a specific surface area of 80 to 100 cm² per 1 cm² of the support and 1 µm of the film thickness which was measured by nitrogen gas adsorption method.

### Example 2

A titanium oxide coating film (anatase-type crystal, hazed) of the present invention was obtained in the same manner as in Example 1 except that the firing temperature was 400°C.

The resulting titanium oxide coating film firmly adhered to the glass plate (support) and the film was observed under a light microscope to find substantially no cracks. This titanium oxide coating film had a thickness of 10 µm and had a specific surface area of 80 to 100 cm² per 1 cm² of the support and 1 µm of the film thickness.

### Example 3

An acid titania sol (CS-N, titanium oxide fine particles of anatase-type crystal and 5 nm in particle size, manufactured by Ishihara Sangyo Kaisha, Ltd.) was dried at 110°C for 5 hours. The resulting titanium oxide fine particle powders were heated at 300°C for 1 hour in the air to obtain titanium oxide particle powders (anatase-type crystal, particle size 11 nm). Then, the following components were shaken in a paint shaker for 5 hours to sufficiently mix and disperse them. This was coated on a glass plate of 100 cm² by a doctor blade and dried and then, was fired at 450°C for 30 minutes to obtain a titanium oxide coating film (anatase-type crystal, translucent) of the present invention.

The resulting titanium oxide coating film firmly adhered to the glass plate (support) and the film was observed under a light microscope to find substantially no cracks. This titanium oxide coating film had a thickness of 2.0 µm.

| | |
|---|---|
| Titanium oxide particle powders | 8.0 g |
| Polyethylene glycol (molecular weight 20000) | 3.2 g |
| Pure water | 14.0 ml |
| Concentrated nitric acid | 0.5 ml |

Catalytic activity of the resulting titanium oxide coating film was examined in the following manner. The titanium oxide coating film was put in a glass container of 8 liters and acetaldehyde which was a malodorous component was added thereto at a concentration of 50 ppm. Then, the glass container was sealed. The titanium oxide coating film was irradiated with a black light for 2 hours so that ultraviolet intensity on the surface of the film reached 1 mW/cm² and the concentration of acetaldehyde after the irradiation was measured to obtain 15 ppm. From this result, it can be seen that the titanium oxide coating film of the present invention is superior in photocatalytic activity.

### Comparative Example 1

Water was added to the wet cake which was obtained in the same manner as in Example 1, but was not subjected to the heating and furthermore, polyethylene glycol (average molecular weight: 15000-25000) was added thereto in an amount of 20% by weight based on the titanium oxide, followed by stirring to obtain a suspension containing 300 g/l of titanium oxide fine particles.

Then, this suspension was coated on a glass plate by a doctor blade and air-dried. Thereafter, the coat was fired at 450°C for 2 hours. As a result, the titanium oxide fine particles peeled off from the glass plate in the form of fragments and a titanium oxide coating film was not able to be formed on the support.

### Example 4

One liter of a solution containing 80 g/l of titanyl sulfate was heated to 85°C and kept at that temperature for 3 hours to hydrolyze titanyl sulfate to obtain titanium oxide fine particles. (A part of the resulting titanium oxide fine particles were taken and filtrated, washed and dried. X-ray diffraction of the resulting product showed that the product had anatase-type crystal structure and had a particle size of 6 nm.)

The resulting titanium oxide fine particles were filtrated, washed and then dispersed in water to prepare a suspension of 200 g/l in terms of TiO₂. Then, aqueous hydrochloric acid solution was added to this suspension to adjust the pH to 1.0. Thereafter, the suspension was charged in an autoclave and subjected to a hydrothermal treatment at 200°C for 13 hours under a saturated vapor pressure. (A part of the resulting suspension of titanium oxide particles was taken and filtrated, washed and dried. X-ray diffraction of the resulting product showed that the product had anatase-type crystal structure and had a particle size of 20 nm.)

Then, the suspension of titanium oxide particles obtained by the hydrothermal treatment was coated on a glass plate by a doctor blade and air-dried. Thereafter, the coat was fired at 450°C for 3 hours to obtain a titanium oxide coating film (anatase-type crystal, transparent) of the present invention.

This titanium oxide coating film firmly adhered to the glass plate (support). The film was observed under a light microscope to find substantially no cracks. This titanium oxide coating film had a thickness of 6 µm and had a specific surface area of 80 to 100 cm² per 1 cm² of the support and 1 µm of the film thickness.

### Example 5

Titanyl sulfate was hydrolyzed an accordance with the process mentioned in Example 4 to obtain titanium oxide fine particles. (A part of the resulting titanium oxide fine particles were taken and filtrated, washed and dried. X-ray diffraction of the resulting product showed that it had anatase-type crystal structure and had a particle size of 5 nm.)

The resulting titanium oxide fine particles were filtrated, washed and then dispersed in water to prepare a suspension of 250 g/l in terms of TiO₂. Then, aqueous nitric acid solution was added to this suspension to adjust the pH to 1.2. Thereafter, the suspension was charged in an autoclave and subjected to a hydrothermal treatment at 150°C for 13 hours under a saturated vapor pressure. (A part of the resulting suspension of titanium oxide particles was taken and filtrated, washed and dried. X-ray diffraction of the resulting product showed that it had anatase-type crystal structure and had a particle size of 13 nm.)

To the suspension of the titanium oxide particles obtained by the above hydrothermal treatment was added polyethylene glycol (average molecular weight: 20000) in an amount of 40% by weight based on TiO₂ in the suspension, followed by heating to 60°C. Then, in the same manner as in Example 4, the suspension was coated on a glass plate, air-dried, and then fired to obtain a titanium oxide coating film (anatase-type crystal, transparent) of the present invention.

This titanium oxide coating film firmly adhered to the glass plate (support). The film was observed under a light microscope to find substantially no cracks. This titanium oxide coating film had a thickness of 7.5 µm and had a specific surface area of 100 to 120 cm² per 1 cm² of the support and 1 µm of the film thickness.

### Example 6

Water was added to the suspension of titanium oxide particles obtained in accordance with the process mentioned in Example 5 to adjust the concentration to 12 g/l based on TiO₂. To 200 ml of this suspension were added 10 g of commercially available hollow glass beads (B28/750 manufactured by 3M Co.) and then, water was removed by an evaporator. The resulting product was dried at 100°C for 2 hours and then, fired at 300°C for 1 hour to obtain a titanium oxide coating film (anatase-type crystal, transparent) of the present invention.

This titanium oxide coating film firmly adhered to the hollow glass beads (support) and substantially no cracks were found according to the observation by a light microscope.

### Example 7

A titanium oxide coating film (anatase-type crystal, transparent) of the present invention was obtained in the same manner as in Example 6 except that solid glass beads (GB503M manufactured by Toshiba Balotyni Co.) were used in place of the hollow glass beads.

This titanium oxide coating film firmly adhered to the solid glass beads (support) and substantially no cracks were found according to the observation by a light microscope.

### Example 8

A titanium oxide coating film (anatase-type crystal, transparent) of the present invention was obtained in the same manner as in Example 6 except that a ceramic honeycomb structure (HONEYCERAM manufactured by Nihon Gaishi K.K.) was used in place of the hollow glass beads.

This titanium oxide coating film firmly adhered to the honeycomb structure (support) and substantially no cracks were found according to the observation by a light microscope.

### Example 9

Sodium hydroxide was added to an acid titania sol (CS-N, titanium oxide fine particles of anatase-type crystal having a particle size of 6 nm, manufactured by Ishihara Sangyo Kaisha, Ltd.) to adjust the pH to 7, followed by carrying out filtration and washing. Water was added to the resulting wet cake to prepare a suspension of titanium oxide fine particles having a concentration of 100 g/l in terms of TiO₂. Then, sodium hydroxide was added to the suspension to adjust the pH to 10 and the suspension was charged in an autoclave and subjected to a hydrothermal treatment at 150°C for 3 hours under a saturated vapor pressure.

Then, nitric acid was added to the suspension of titanium oxide particles (anatase-type crystal, particle size 18 nm) after subjected to the hydrothermal treatment to neutralize to a pH of 7, followed by carrying out filtration and water washing. Water was further added to the resulting cake of titanium oxide particles to prepare a suspension of titanium oxide particles having a concentration of 500 g/l in terms of TiO₂. Nitric acid was added to the suspension to adjust the pH to 1. This suspension was coated on a glass plate of 100 cm² by a spin coater and dried and then, fired at 500°C for 3 hours to obtain a titanium oxide coating film (anatase-type crystal structure, translucent).

This titanium oxide coating film firmly adhered to the glass plate (support) and substantially no cracks were found according to the observation by a light microscope. This titanium oxide coating film of the present invention had a thickness of 1.0 µm.

The catalytic activity of the resulting titanium oxide coating film was examined by the method used in Example 3. As a result, the acetaldehyde concentration after irradiated with light was 13 ppm. It can be seen from the result that the titanium oxide coating film of the present invention is superior in photocatalytic activity.

According to the process of the present invention there is obtained a titanium oxide coating film having a large specific surface area, less in occurrence of cracks and good in adhesion to a support can be produced by firing the titanium oxide particles coated onto a support to firmly adhere them to a support.

The titanium oxide coating film of the present invention is also excellent in optical properties, optoelectric transducing properties and catalytic properties and is useful for optical materials, electronic materials, optoelectric transducing materials, decorative materials, catalysts, photocatalysts, catalyst carriers, adsorbents and bioreactors. The titanium oxide coating film of the present invention is especially excellent in photocatalytic activity, and injurious materials can be rapidly and efficiently removed utilizing the excellent photocatalytic activity. Thus, it is markedly useful not only for industrial uses, but also as household deodorants and the like. In addition, the titanium oxide coating film of the present invention can be used for a long period of time, is high in safety, can be applied to removal of a wide variety of injurious materials and does not pollute the environment even if it is abandoned. Therefore, it is industrially very useful.

Moreover, according to the process of the present invention, the titanium oxide coating film can be simply allowed to adhere to supports such as glass, metals, ceramics and plastics and further, the resulting film has a stable quality.

## Claims

1. A process for producing a titanium oxide coating film which comprises heat treating titanium oxide fine particles to carry out crystal growth of the fine particles, thus obtaining titanium oxide particles, then coating the resulting titanium oxide particles on a support and firing the coated support to allow the particles to firmly adhere to the support.

2. A process according to claim 1 wherein the titanium oxide particles have an average particle size of 10 to 100 nm.

3. A process according to claim 1 which comprises carrying out the crystal growth of the titanium oxide fine particles by heating the fine particles at a temperature of 200 to 600°C to prepare titanium oxide particles, then coating the resulting titanium oxide particles on a support and firing the coated support at a temperature higher than the heating temperature for the crystal growth to allow the particles to firmly adhere to the support.

4. A process according to claim 1 wherein the titanium oxide fine particles are subjected to a hydrothermal treatment at 100°C or higher to carry out the crystal growth of the fine particles.

5. A process according to claim 1 wherein a suspension of the titanium oxide fine particles is adjusted to a pH of 4 or lower or 9 or higher and then, the suspension is subjected to a hydrothermal treatment at 100°C or higher to carry out the crystal growth of the titanium oxide fine particles.

6. A process according to claim 1 wherein the titanium oxide fine particles containing rutile-type titanium oxide are subjected to a hydrothermal treatment at 100°C or higher to carry out the crystal growth of the fine particles.

7. A process according to claim 1 wherein titanyl sulfate is hydrolyzed to obtain the titanium oxide fine particles and the resulting titanium oxide fine particles are subjected to a hydrothermal treatment at 100°C or higher to carry out the crystal growth of the fine particles.

8. A process according to claim 1 wherein a suspension of the titanium oxide particles is adjusted to a pH of 4 or lower or 9 or higher and then the suspension is coated on a support and fired to allow the titanium oxide particles to firmly adhere to the support.

## Patentansprüche

1. Verfahren zur Herstellung eines filmartigen Titanoxidüberzugs durch Erwärmen feiner Titanoxidteilchen zur Herbeiführung eines Kristallwachstums der feinen Teilchen und zur Bildung von Titanoxidteilchen, anschließendes Auftragen der gebildeten Titanoxidteilchen auf einen Träger und Brennen des beschichteten Trägers, um die Teilchen an den Träger fest zum Haften zu bringen.

2. Verfahren nach Anspruch 1, wobei die Titanoxidteilchen eine durchschnittliche Teilchengröße von 10-100 nm aufweisen.

3. Verfahren nach Anspruch 1, wobei das Kristallwachstum der feinen Titanoxidteilchen zur Herstellung von Titanoxidteilchen durch Erwärmen der feinen Teilchen auf eine Temperatur von 200-600°C erfolgt, die erhaltenen Titanoxidteilchen auf einen Träger aufgetragen werden und der beschichtete Träger bei einer Temperatur oberhalb der Erwärmungstemperatur für das Kristallwachstum gebrannt wird, um die Teilchen fest am Träger zum Haften zu bringen bzw. zu befestigen.

4. Verfahren nach Anspruch 1, wobei die feinen Titanoxidteilchen zur Herbeiführung des Kristallwachstums der feinen Teilchen einer hydrothermalen Behandlung bei 100°C oder darüber unterworfen werden.

5. Verfahren nach Anspruch 1, wobei eine Suspension der feinen Titanoxidteilchen auf einen pH-Wert von 4 oder darunter oder 9 oder darüber eingestellt und danach die Suspension zur Herbeiführung eines Kristallwachstums der feinen Titanoxidteilchen einer hydrothermalen Behandlung bei 100°C oder höher unterworfen wird.

6. Verfahren nach Anspruch 1, wobei die feinen Titanoxidteilchen mit Titanoxid vom Rutil-Typ zur Herbeiführung eines Kristallwachstums der feinen Teilchen einer hydrothermalen Behandlung bei 100°C oder darüber unterworfen werden.

7. Verfahren nach Anspruch 1, wobei zur Bildung der feinen Titanoxidteilchen Titanylsulfat hydrolysiert und die gebildeten feinen Titanoxidteilchen zur Herbeiführung eines Kristallwachstums der feinen Teilchen einer hydrothermalen Behandlung bei 100°C oder darüber unterworfen werden.

8. Verfahren nach Anspruch 1, wobei eine Suspension der Titanoxidteilchen auf einen pH-Wert von 4 oder darunter oder 9 oder darüber eingestellt und danach die Suspension auf einen Träger aufgetragen und gebrannt wird, um die Titanoxidteilchen fest an dem Träger zum Haften zu bringen.

## Revendications

1. Procédé de préparation d'un film de revêtement d'oxyde de titane, qui consiste à traiter à chaud de fines particules d'oxyde de titane pour réaliser la croissance cristalline des fines particules, en obtenant ainsi des particules d'oxyde de titane, puis à revêtir un support des particules d'oxyde de titane résultantes et à cuire le support revêtu, pour permettre aux particules d'adhérer fermement au support.

2. Procédé conformément à la Revendication 1, dans lequel les particules d'oxyde de titane ont une taille moyenne de particules de 10 à 100 nm.

3. Procédé conformément à la Revendication 1, qui consiste à réaliser la croissance cristalline des fines particules d'oxyde de titane en chauffant les fines particules à une température de 200 à 600°C pour préparer des particules d'oxyde de titane, puis à revêtir un support des particules d'oxyde de titane résultantes et à cuire le support revêtu à une température supérieure à la température de chauffage destinée à réaliser la croissance cristalline, pour permettre aux particules d'adhérer fermement au support.

4. Procédé conformément à la Revendication 1, dans lequel les fines particules d'oxyde de titane sont soumises à un traitement hydrothermal à 100°C ou plus, pour réaliser la croissance cristalline des fines particules.

5. Procédé conformément à la Revendication 1, dans lequel une suspension des fines particules d'oxyde de titane est ajustée à un pH de 4 ou moins, ou de 9 ou plus, et ensuite, la suspension est soumise à un traitement hydrothermal à 100°C ou plus, pour réaliser la croissance cristalline des fines particules d'oxyde de titane.

6. Procédé conformément à la Revendication 1, dans lequel les fines particules d'oxyde de titane contenant de l'oxyde de titane du type rutile, sont soumises à un traitement hydrothermal à 100°C ou plus, pour réaliser la croissance cristalline des fines particules.

7. Procédé conformément à la Revendication 1, dans lequel du sulfate de titanyle est hydrolysé pour obtenir les fines particules d'oxyde de titane, et les fines particules d'oxyde de titane résultantes sont soumises à un traitement hydrothermal à 100°C ou plus pour réaliser la croissance cristalline des fines particules.

8. Procédé conformément à la Revendication 1, dans lequel une suspension des particules d'oxyde de titane est ajustée à un pH de 4 ou moins, ou de 9 ou plus, et ensuite la suspension est appliquée sur un support et cuite pour permettre aux particules d'oxyde de titane d'adhérer fermement au support.
